# DEMANDE DE BREVET EUROPEEN

(11) **EP 0 683 534 A1**
(43) Date de publication de la demande: **22.11.1995**
(21) Numéro de dépôt: 95401124.3
(22) Date de dépôt: 16.05.1995
(51) Int. Cl.: H01L 41/08, H01L 41/04

(54) **Electrodes pour dispositif piézo-électrique**

(30) Priorité: 17.05.1994 FR 9405991
(71) Demandeur: ETAT FRANCAIS, Représenté par le Délégué Général, pour l'Armement, Paris 7ème (FR)
(72) Inventeur: Scarpitta, Alain, F-83200 Toulon (FR); Boisrayon, Michel, F-83330 Le Beausset (FR); Meyer, Luc, F-83130 La Farlede (FR)

(57) **Abrégé**

L'invention concerne le domaine de la piézo-électricité et a plus particulièrement pour objet un dispositif piézo-électrique comprenant au moins un couple d'électrodes (10,20) et un matériau piézo-électrique (30) séparant les dites électrodes, caractérisé en ce que chacune des électrodes comporte une plaque transversale (10) et en ce que l'une de ces électrodes comportent n plaques longitudinales (11₁ à 11ₙ) solidaires de la plaque (10) et formant un angle α avec cette dernière, l'autre en comportant n+1 (21₁ à 21ₙ₊₁), n étant au moins égal à 1, l'agencement des plaques longitudinales étant tel que les plaques (11₁ à 11ₙ) s'imbriquent entre les plaques (21₁ à 21ₙ₊₁).

## Description

L'invention concerne le domaine de la piézo-électricité et, plus particulièrement, des électrodes pour dispositif piézo-électrique pouvant être, par exemple, à polarisation variable et réglable.

Les dispositifs piézo-électriques utilisés à ce jour, tels que ceux décrit dans le brevet EP0532971 mettent en oeuvre des électrodes planes ou, tels que certains de ceux décrits dans la demande de brevet français N° 94 04853 déposée par le demandeur, cylindriques.

Cependant, avec des électrodes planes, il est difficile d'utiliser un matériau piézo-électrique autrement qu'en mode de compression. On peut éventuellement concevoir des montages permettant d'exercer des cisaillements sur des électrodes planes, mais ils sont fragiles et d'une efficacité limitée. Or, plusieurs dispositifs piézo-électriques décrits dans ladite demande, présentent des caractéristiques optimales lorsqu'ils sont excités par un cisaillement.

Les électrodes cylindriques peuvent être également excitées en mode de cisaillement comme le montre ladite demande. Cependant, il est difficile d'obtenir des cisaillements importants à l'intérieur du matériau piézo-électrique et, à volume ou à encombrement donné, la capacité électrique obtenue est faible. Or, lorsqu'on utilise par exemple des hydrophones, il est très important d'avoir des capacités électriques au moins supérieures à 100_{P}F, pour éviter l'apparition de parasites électriques ou l'emploi de préamplificateurs coûteux et à hautes performances. Lorsque l'encombrement de l'hydrophone est très limité on peut ainsi rencontrer des difficultés parfois insurmontables.

L'un des buts de la présente invention est de permettre de faire fonctionner ces matériaux précisément dans le mode de cisaillement.

Pour cela, il est apparu, de façon surprenante, que la sensibilité du capteur dépend en grande partie de la forme des électrodes qui servent à récupérer le signal utile et à appliquer la tension de polarisation. L'invention consiste à proposer des électrodes dont la forme permet d'améliorer fortement la sensibilité du capteur ainsi que sa capacité électrique.

Un dispositif piézoélectrique selon l'invention comporte au moins un couple d'électrodes et un matériau piézo-électrique séparant les dites électrodes et est caractérisé en ce que chacune des électrodes comporte une plaque transversale et en ce que l'une de ces électrodes comportent n plaques longitudinales solidaires de la plaque transversale et formant un angle α1 avec cette dernière, n étant au moins égal à 1, et l'autre comportent m plaques longitudinales solidaires de la plaque transversale et formant un angle α2 avec cette dernière, m étant au moins égal à 2, l'agencement des plaques longitudinales étant tel que les plaques de l'une des électrodes s'imbriquent entre les plaques de l'autre électrode.

Selon une caractéristique privilégiée, m est égal à n+1.

Selon une caractéristique particulière, les plaques longidudinales d'une même électrode, sont rectangulaires, parallèles entre elles et équidistantes et perpendiculaires à la plaque transversale.

Selon une autre caractéristique, les plaques transversales sont de forme polygonale.

Selon une autre caractéristique, les plaques transversales sont de forme circulaire.

Selon une autre caractéristique particulière, les électrodes d'un même couple sont en matériaux différents et l'une au moins desdites électrodes est en matériau métallique.

Selon une autre caractéristique, l'une au moins de ces électrodes est réalisée en matériau plastique injecté recouvert d'un dépôt métallique.

Selon une autre caractéristique, l'une au moins de ces électrodes est réalisée en matériau composite composé d'une résine et de verre.

Selon une caractéristique additionnelle, un dispositif selon l'invention comporte des moyens de génération d'une tension de polarisation et des moyens de réglage de la valeur de cette tension de polarisation.

Selon une caractéristique avantageuse, le matériau piézo-électrique est un matériau composite composé d'une matrice de polymère ou de produit organique diélectrique, non piézo-électrique ou faiblement piézo-électrique, et de particules piézo-électriques provenant d'un ou de plusieurs matériaux piézo-électriques différents.

Selon une caractéristique additionnelle, l'espace entre les électrodes est partiellement rempli par ledit matériau piézo-électrique.

Selon une autre caractéristique, les plaques longitudinales de l'une des électrodes forment des angles, respectivement α1₁ à α1ₙ, avec la plaque transversale.

Un tel dispositif peut être notamment utilisé dans les transducteurs électromécaniques mis en oeuvre dans les antennes sonar. Ces transducteurs peuvent être des hydrophones, des accéléromètres, des capteurs de pression hydrostatique, de déformation, de force ou de température ou des systèmes complexes pouvant associer ces différentes fonctions. Ce dispositif peut être également utilisé dans l'air, dans des microphones, des accéléromètres, des claviers de téléscripteurs ou d'ordinateurs, des détecteurs de chaleur, des revêtements piézochromes.

De plus, un capteur utilisant un dispositif piézo-électrique peut aussi être sollicité avec des performances convenables en exploitant et en associant le mode de polarisation piézo-électrique au mode de fonctionnement pyroélectrique. Ce dernier mode est mis en oeuvre au moyen d'un réseau de résistances incorporées ou associées au dit matériau. Dans ce cas, la forme des électrodes a également une grande importance et l'invention permet d'améliorer de manière sensible les performances du capteur.

Ces électrodes peuvent être utilisées en combinaison avec un ou plusieurs matériaux piézo-électriques, qui peuvent être composites ou non composites et être mises en oeuvre dans des capteurs piézo-électriques classiques, à matériaux prépolarisés, et donc à polarisation fixe.

D'une manière générale, l'invention permet, pour un encombrement donné du capteur, d'augmenter sensiblement la capacité électrique de ce capteur par rapport aux formes d'électrodes adoptées traditionnellement.

D'autres avantages et caractéristiques de la présente invention apparaîtront dans la description de variantes de réalisation non limitatives, au regard des figures annexées parmi lesquelles :
- la figure 1 présente le schéma d'un dispositif à polarisation variable selon l'état de la technique.
- les figures 2a et 2b montrent respectivement une coupe transversale et une vue en perspective d'un couple d'électrodes selon une variante de réalisation de l'invention,
- les figures 3a à 3e présentent des vues, en perspective, de cinq variantes de réalisation d'une électrode selon l'invention,
- la figure 4 présente un schéma d'un moule servant à la fabrication d'un dispositif piézoélectrique selon un variante de réalisation de l'invention,
- la figure 5 montre un schéma du positionnement des électrodes à l'intérieur du moule,
- la figure 6 illustre la phase de connexion électrique des électrodes,
- la figure 7 présente un schéma d'un couple d'électrodes après injection du matériau piézo-électrique et surmoulage,
- la figure 8 montre les moyens composant un dispositif piézo-électrique à polarisation variable,
- la figure 9 présente une courbes de sensibilité d'un hydrophone utilisant des électrodes selon l'invention,
- la figure 10 montre un couple d'électrode, avant injection du matériau piézo-électrique, selon une autre variante de réalisation.

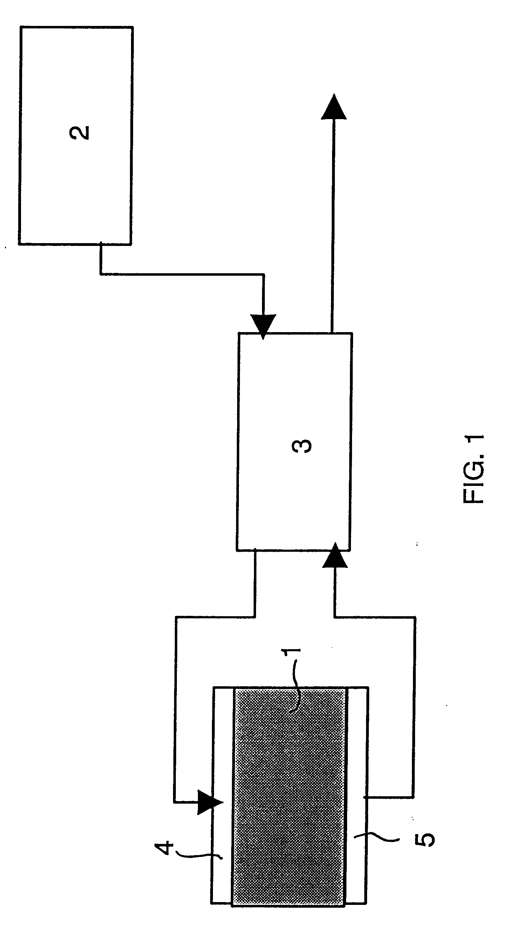

La figure 1a illustre le schéma d'un dispositif piézo-électrique comportant un disque 1 constitué d'un matériau piézo-électrique, et des moyens de génération d'une tension U de polarisation réglable, ces moyens comportant une source de tension réglable 2, un amplificateur polarisateur 3 et des électrodes 4 et 5, l'amplificateur comprenant notamment un préamplificateur différentiel. Un tel dispositif fonctionne en accéléromètre.

Les électrodes 4 et 5 enserrent le disque 1 selon l'état de la technique décrit notamment dans le brevet EP532971.

On rappelle qu'un dispositif piézo-électrique à polarisation variable permet, entre autres, de faire varier la sensibilité d'un capteur et de corriger, ou faire évoluer, les caractéristiques de directivité d'une antenne comprenant un certain nombre de capteurs utilisant ce dispositif.

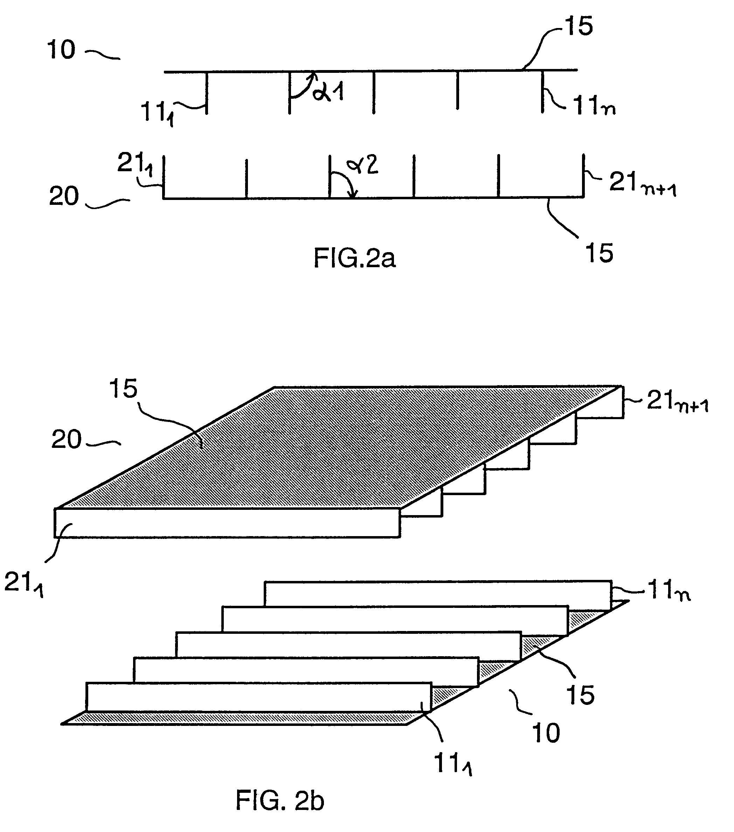

Les figures 2a, 2b montrent respectivement une coupe transversale et une vue en perspective d'un couple d'électrodes 10,20 selon une variante de réalisation de l'invention.

Chacune de ces électrodes respevtivement 10 et 20 comporte une plaque transversale 15, et un ensemble, respectivement 11 et 21, de n plaques longitudinales pour l'une et n+1 plaques longitudinales pour l'autre. Ces plaques longitudinales 11₁ à 11ₙ, respectivement 21₁ à 21ₙ₊₁, forme avec la plaque transversale à laquelle elles sont solidaires, un angle α de 90 degrés. De plus, elles sont équidistantes. L'agencement des plaques longitudinales est tel que les plaques 11₁ à 1₁ₙ s'imbriquent entre les plaques 21₁ à 21ₙ₊₁. L'une des électrodes peut être considérée comme une électrode mâle et l'autre comme une électrode femelle.

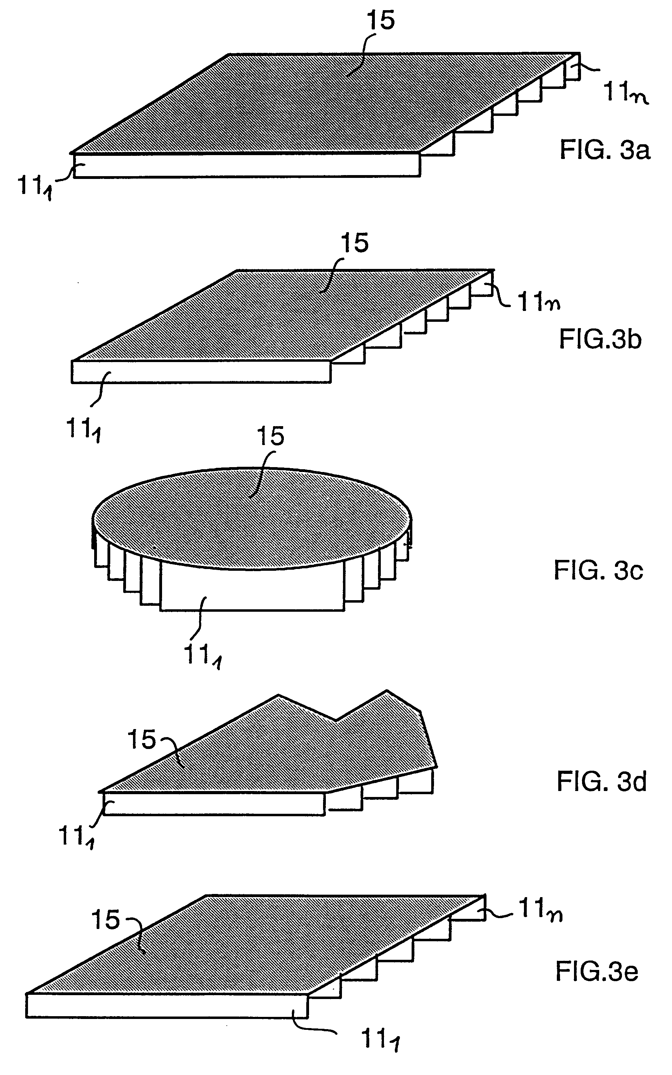

Les figures 3a à 3e présentent une vue en perspective de cinq variantes de réalisation de l'invention.

Dans la première, la plaque transversale 15 consiste en une plaque de forme rectangulaire et les plaques longitudinales 11₁ à 11ₙ sont constituées par des plaques de même épaisseur, longueur et hauteur et disposées parallèlement les unes par rapport aux autres mais de façon non équidistante.

Dans la seconde, la plaque transversale 15 consiste en une plaque de forme carrée et les plaques longitudinales 11₁ à 11ₙ sont constituées par des plaques de même longueur et hauteur mais d'épaisseur différente et disposées parallèlement les unes par rapport aux autres et de façon non équidistante.

Dans la troisième, la plaque transversale 15 consiste en une plaque de forme cylindrique et les plaques longitudinales 11₁ à 11ₙ sont constituées par des plaques de même épaisseur et hauteur mais de longueur différente et disposées parallèlement les unes des autres et de façon équidistante.

Dans la quatrième, la plaque transversale 15 est polygonale et les plaques longitudinales 11₁ à 11ₙ sont constituées par des plaques de même épaisseur et hauteur mais de longueur différente et disposées parallèlement les unes des autres et de façon équidistante.

Dans la cinquième, la plaque transversale 15 consiste en une plaque de forme carrée et les plaques longitudinales 11₁ à 11ₙ sont constituées par des plaques de même longueur et hauteur mais d'épaisseur différente et disposées parallèlement les unes par rapport aux autres et de façon équidistante (cas le plus fréquent).

Dans cet exemple de réalisation, les électrodes sont composées du même matériau, ce dernier pouvant être à titre d'exemple, un alliage d'aluminium, tel que AU4G, AG5, cupro-aluminium..., de l'acier inoxydable ou un alliage de cuivre. Cependant on peut aussi les concevoir sous forme de pièces injectées revêtues d'un dépôt métallique, tel, par exemple que de l'or ou de l'argent, ou sous formes de pièces moulées en composites verre-résine analogues à celles que l'on utilise pour les circuits imprimés. Dans ce dernier cas, le dépôt métallique peut être un dépôt cuivreux ou tout autre dépôt métallique adéquat.

Dans le cas où les électrodes sont réalisées en matériau métallique, elles sont tout d'abord découpées dans des plats de façon à obtenir les dimensions générales externes voulues, correspondant généralement à celles de la plaque transversale 15. Puis elles sont fraisées au moyen de fraises à trois tailles pour obtenir les plaques constitutives des plaques longitudinales correspondantes. Le cas échéant, ces plaques sont ensuite retaillées pour obtenir les formes souhaitées.

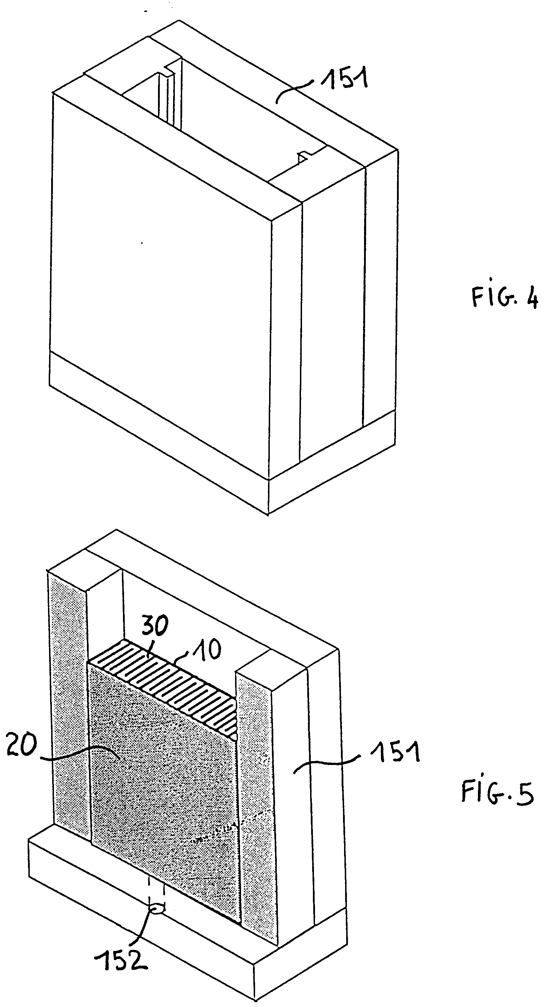

Les électrodes sont ensuite positionnées dans un moule 151, métallique ou en matière plastique, tel que celui montré à la figure 4. Le matériau piézo-électrique est ensuite injecté ou déposé entre ces électrodes. Un câble électrique à deux conducteurs est ensuite rapporté et soudé sur ces électrodes. L'ensemble est surmoulé, à froid ou à chaud, au moyen d'une résine ou d'un caoutchouc convenablement choisi et destiné à protéger la partie sensible du capteur et à garantir son étanchéité dans le cas d'une utilisation en immersion.

Une première variante de mise en oeuvre de l'invention est décrite ci-après, au regard des figures 5 à 9.

Les électrodes 10,20 sont en cupro-aluminium Cu-Al-9Ni-5Fe2. La plaque transversale 15 de chacune de ces électrodes est constituée d'une plaque de forme carrée et de 2mm d'épaisseur. Les plaques longitudinales 11₁ à 11ₙ respectivement 21₁ à 21ₙ₊₁ sont constituées de plaques rectangulaires de 8mm de hauteur, 49mm de longueur et 1mm d'épaisseur, deux plaques consécutives étant espacées de 3mm.

Les électrodes 10,20 sont positionnées au moyen du moule PVC 151, comme montré à la figure 5. L'intervalle entre chaque plaque consécutive, l'une appartenant à l'électrode 10 et l'autre à l'électrode 20, est donc de 1 mm.

Le matériau piézo-électrique 30 utilisé dans cette variante de réalisation est un matériau composite constitué d'une matrice en prépolymère et de particules piézo-électriques.

La matrice de prépolymère utilisée est une résine silicone se présentant sous la forme d'une résine A et d'un durcisseur B. On a pesé 40 grammes de part A et 4 grammes de part B et on les a mélangés avec soin pendant 2 minutes au moyen d'un mélangeur.

Les particules piézo-électriques utilisées sont des microcristaux de brushite (CaHPO4). La quantité de microcristaux utilisée est de 2,2 g.

On a ensuite incorporé progressivement dans le mélange de prépolymère les particules piézo-électriques et on a brassé l'ensemble pendant 3 minutes jusqu'à homogénéisation complète. Le mélange a ensuite été dégazé au moyen d'une pompe à vide mécanique pendant 5 minutes.

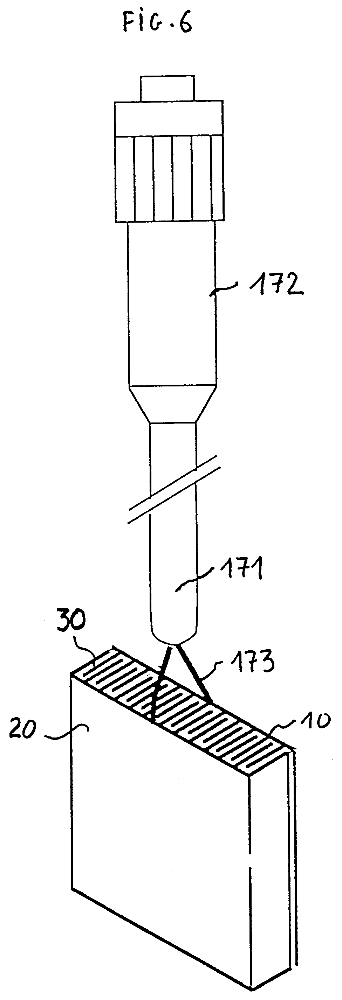

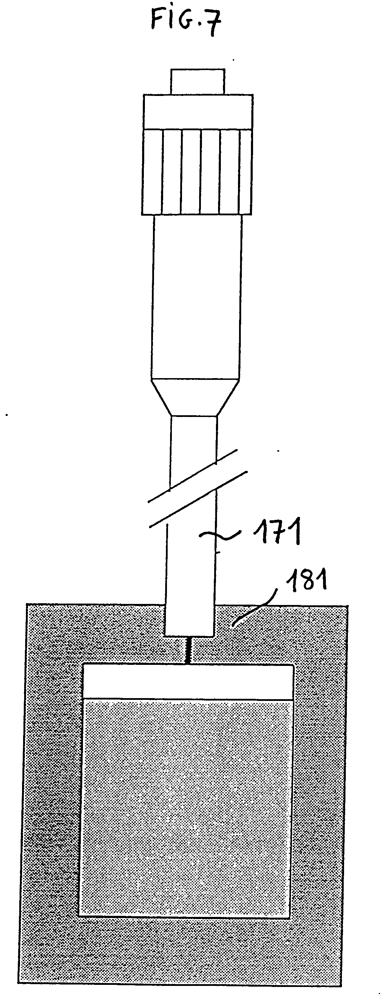

La résine étant toujours à l'état de prépolymère, le mélange 30 est injecté, à travers un orifice d'injection 152, dans le moule en PVC 151 pourvu desdites électrodes métalliques 10 et 20. Ce moule a la forme d'un parallélépipède ayant pour dimensions 73 mm x 35 mm x 80 mm.On laisse le mélange 30 de résine et de microcristaux se polymériser pendant 48 heures. On rapporte sur les électrodes 10 et 20 un câble électrique coaxial 171 dont la tresse 173, comme montré à la figure 6, est reliée à l'électrode 10. Le conducteur central 174 du câble 171 est relié à l'électrode 20. L'ensemble est placé dans un autre moule pour recevoir un enrobage extérieur 181 de résine polyuréthanne comme illustré à la figure 7. Au cours de cette opération une partie du câble 171 est surmoulé par l'enrobage 181. On obtient ainsi un capteur qui est utilisé comme hydrophone.

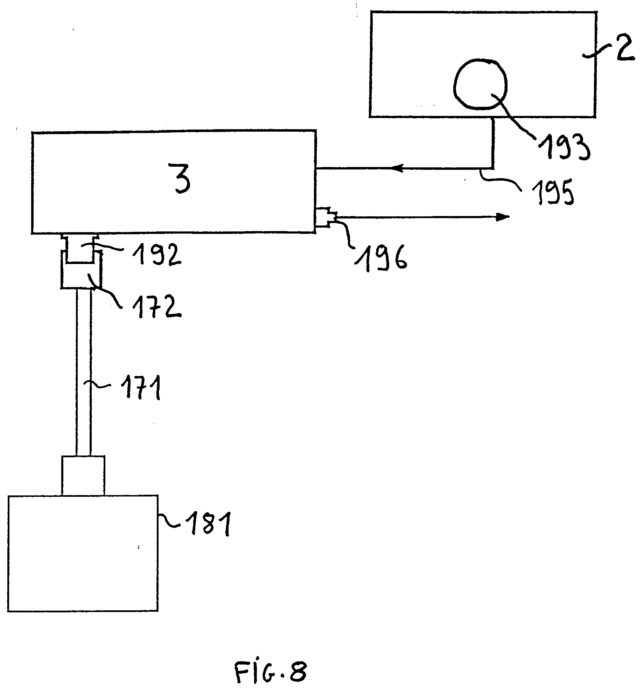

Comme présenté à la figure 8, la prise 172 est ensuite reliée à un amplificateur/polarisateur 3, pourvu d'une embase coaxiale 192 qui permet simultanément de recueillir le signal délivré par l'hydrophone et de le soumettre à une tension de polarisation continue. Cette tension peut varier, en fonction de la sensibilité que l'on désire, de 0V à 2kV. Elle est réglée par un potentiomètre 193.

L'amplificateur/polarisateur 3 est relié à une source de tension continue 2 par l'intermédiaire d'un câble 195 et d'une prise 196 qui permet de récupérer le signal basse tension délivré par l'hydrophone et amplifié par les moyens 3.

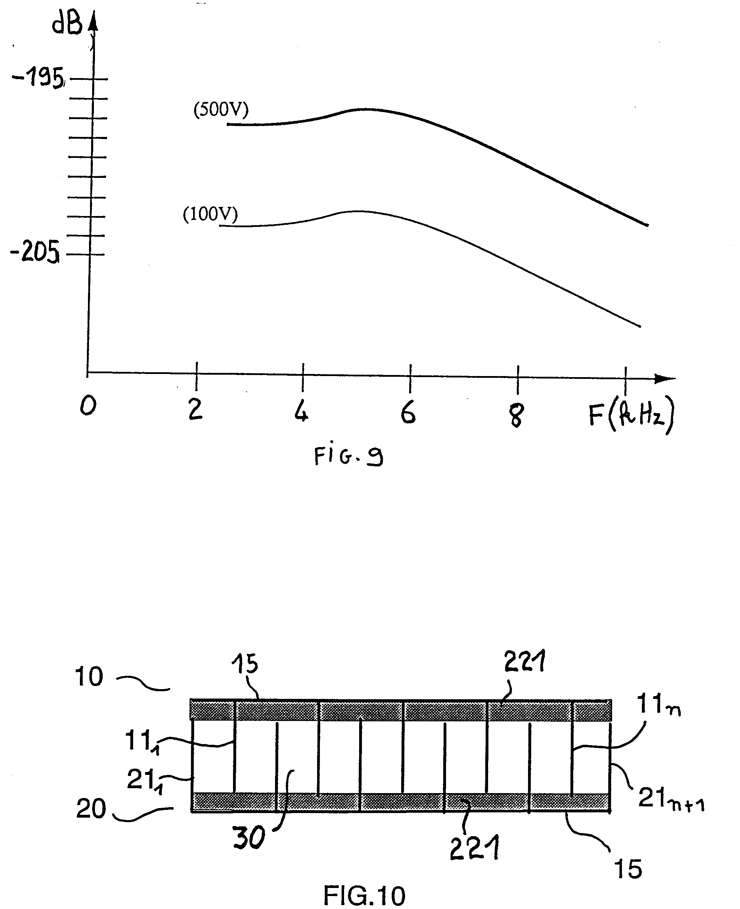

La sensibilité de cet hydrophone a été évaluée dans une cuve acoustique. Les mesures ont été faites en utilisant un signal acoustique étalonné dans une bande de fréquence allant de 2,5 kHz à 10 kHz. En l'absence de tension de polarisation, l'hydrophone ne présente pas de sensibilité mesurable. On obtient une sensibilité mesurable à partir d'une tension de polarisation de 100 V, et la sensibilité optimale est acquise pour une tension de polarisation de 500 V. La figure 9 représente les courbes de sensibilité obtenues à 100 V et 500 V dans la bande de fréquences précitées. La sensibilité est exprimée en décibels, la référence étant de 1V/µPa.

Une deuxième variante de mise en oeuvre de l'invention, relative à un hydrophone composite fonctionnant en cisaillement pur, est décrite ci-après.

Les électrodes sont en cuproaluminium Cu-Al-9Ni-5Fe2. Les électrodes sont géométriquement identiques à celles précédemment décrites et de dimensions identiques.

Le composite utilisé comprend une matrice en prépolymère et des particules piézoélectriques constituées par .des microcristaux de brushite (CaHPO4). Le procédé mis en oeuvre pour réaliser le dispositif piézo-électrique est similaire à celui précédemment décrit. Toutefois, avant la mise en oeuvre du prépolymère, des bandelettes en téflon 211 sont disposées, comme le représente la figure 10, contre la plaque interne de la plaque 15 de chacune des électrodes 10,20.

La résine étant toujours à l'état de prépolymère le mélange 30 a été injecté, à travers l'orifice d'injection 152 du moule en PVC 151 et pourvu desdites électrodes métalliques 10 et 20.

A l'issue du surmoulage, on obtient un capteur qui est utilisable comme hydrophone et qui fonctionne en cisaillement pur, puisque les deux lames d'air, obtenues après élimination des bandelettes de téflon, empêchent les ondes de compression de pénétrer la majeure partie de l'élément sensible de l'hydrophone, ledit élément sensible étant constitué par ledit composite piézoélectrique. 0

## Revendications

1. Dispositif piézoélectrique comprenant au moins un couple d'électrodes (10,20) et un matériau piézo-électrique (30) séparant les dites électrodes, caractérisé en ce que chacune des électrodes comporte une plaque transversale (10) et en ce que l'une de ces électrodes comportent n plaques longitudinales (11₁ à 11ₙ) solidaires de la plaque (10) et formant un angle α1 avec cette dernière, n étant au moins égal à 1, et l'autre comportent m plaques longitudinales (21₁ à 21ₘ) solidaires de la plaque (10) et formant un angle α2 avec cette dernière, m étant au moins égal à 2, l'agencement des plaques longitudinales étant tel que les plaques (11₁ à 11ₙ) s'imbriquent entre les plaques (21₁ à 21ₘ).

2. Dispositif piézoélectrique selon la revendication 1, caractérisé en ce que m est égal à n+1.

3. Dispositif piézoélectrique selon l'une quelconque des revendications 1 et 2, caractérisé en ce que les plaques longitudinales d'une même électrode, sont parallèles entre elles et équidistantes.

4. Dispositif selon l'une quelconque des revendications 1 à 3, caractérisé en ce que les plaques longitunales sont rectangulaires.

5. Dispositif selon l'une quelconque des revendications 1 à 4, caractérisé en ce que les angles α1 et α2 sont égaux à 90 degrés.

6. Dispositif selon l'une quelconque des revendications 1 à 5, caractérisé en ce que l'une au moins des plaques transversales (10) du couple d'électrodes est de forme polygonales.

7. Dispositif selon l'une quelconque des revendications 1 à 6, caractérisé en ce que l'une au moins des plaques transversales (10) est de forme circulaire.

8. Dispositif selon l'une quelconque des revendications 1 à 7, caractérisé en ce que l'une au moins de ces électrodes est réalisée dans un matériau métallique.

9. Dispositif selon l'une quelconque des revendications 1 à 8, caractérisé en ce que l'une au moins de ces électrodes est réalisée en matériau plastique injecté recouvert d'un dépôt métallique.

10. Dispositif selon l'une quelconque des revendications 1 à 7, caractérisé en ce que l'une au moins de ces électrodes est réalisée en matériau composite composé d'une résine et de verre.

11. Dispositif selon l'une quelconque des revendications 1 à 10, caractérisé en ce qu'il comporte des moyens (2) de génération d'une tension de polarisation et des moyens (193) de réglage de la valeur de cette tension de polarisation.

12. Dispositif selon l'une quelconque des revendications 1 à 11, caractérisé en ce que le matériau piézo-électrique (30) est un matériau composite composé d'une matrice de polymère ou de produit organique diélectrique, non piézo-électrique ou faiblement piézo-électrique, et de particules piézo-électriques provenant d'un ou de plusieurs matériaux piézo-électriques différents.

13. Dispositif selon la revendication 12, caractérisé en ce que l'espace libre entre les électrodes est partiellement rempli par ledit matériau piézo-électrique (30).

14. Dispositif selon l'une quelconque des revendications 1 à 13, caractérisé en ce que les plaques longitudinales (11₁ à 11ₙ) solidaires de la plaque (10) forment des angles, respectivement α1₁ à α1ₙ, avec cette dernière.
